Europäisches Patentamt

European Patent Office

Office européen des brevets

(19)

(11) EP 1 087 534 A1

## (12) EUROPEAN PATENT APPLICATION

(43) Date of publication:
  28.03.2001  Bulletin 2001/13

(51) Int Cl.$^7$: H03M 13/09

(21) Application number: 00308425.8

(22) Date of filing: 26.09.2000

(84) Designated Contracting States:
  AT BE CH CY DE DK ES FI FR GB GR IE IT LI LU
  MC NL PT SE
  Designated Extension States:
  AL LT LV MK RO SI

(30) Priority: 27.09.1999  US 406313

(71) Applicant: Texas Instruments Incorporated
  Dallas, Texas 75251 (US)

(72) Inventors:
  • Cox, Darrell K.
    Danison, Texas 75021 (US)
  • Chishtie, Mansoor A.
    Dallas, Texas 75243 (US)

(74) Representative: Potter, Julian Mark
  D. Young & Co.,
  21 New Fetter Lane
  London EC4A 1DA (GB)

## (54) Method and apparatus for calculation of cyclic redundancy check

(57)  A cyclic redundancy check is calculated in a pipelined processor using a software process on independent data streams (30) that performs contemporaneous accesses to a CRC look-up table. Because the CRC is processing independent data streams, the latencies in reading a CRC value from the look-up table is effectively diminished.

FIG. 2

EP 1 087 534 A1

**EP 1 087 534 A1**

**Description**

This invention relates in general to data communications and, more particularly, to a method and apparatus for performing a cyclic redundancy check.

Programmable microprocessors and digital signal processors (DSPs) are often used to compute the cyclic redundancy check (CRC) of a bit stream. Since the CRC is a bit-oriented process, typical CRC computations performed by the processors are based on bit-by-bit processing. While hardware bit-by-bit CRC processing is very efficient, software bit-by-bit CRC processing inefficiently consumes processor cycles, since most microprocessors and DSPs are designed for word-oriented processing (for example, in sixteen or thirty-two bit words). Accordingly, current CRC calculation methods employ a word-oriented method of CRC computation that uses lookup tables to avoid processing one bit at a time. The lookup table approach allows the microprocessor or DSP to process one word at a time. This approach is possible because of the CRC computation is a linear transformation.

On many microprocessors, memory read accesses are pipelined, resulting in a certain delay between the time a read access is requested and the time that the read value is available for processing. On pipelined processors, this read latency (rather than the available processor resources required to process the data) determines the minimum instruction cycles needed by each CRC loop iteration. In the case of a CRC computation using look-up tables, no new CRC address computation can commence until the previous CRC value from the look-up table is obtained. This latency sets a lower bound on the efficiency of a CRC implementation using look-up tables.

Therefore a need has arisen for a method and apparatus for reducing the effective read latency in a software CRC computation.

In a first embodiment cyclic redundancy checks are calculated in software by receiving a data stream and separating the data stream into two or more intermediate data streams. An intermediate cyclic redundancy check is generated on each intermediate data stream. The final cyclic redundancy check is generated from said intermediate cyclic redundancy checks.

In a second embodiment, multiple cyclic redundancy checks are generated from multiple independent data streams. Accesses to a look-up table used in generating the CRC are performed simultaneously for each of the independent data streams, at least in part.

Embodiments of the present invention provide significant advantages over the prior art. In particular, the effective number of cycles used to calculate the CRC on a data stream is greatly reduced, due to the reduction of wasted processing cycles caused by read latencies.

For a more complete understanding of the present invention, and the advantages thereof, reference is now made to the following description, provided by way of example only, taken in conjunction with the accompanying drawings, in which:

Figures 1a and 1b illustrate a prior art solution for software calculation of a CRC;
Figure 2 illustrates a block diagram showing an method for software calculation of a CRC using multiple intermediate data streams;
Figure 3 illustrates a block diagram illustrating the basic processor resources used in calculating the CRC by the method of Figure 2;
Figure 4 illustrates a basic timing diagram showing the overlapping calculations of the intermediate CRC values;
Figure 5a and 5b illustrate generation of a CRC look-up table for multiple intermediate data streams; and
Figures 6a and 6b illustrate a second embodiment of the present invention for calculating multiple independent CRC values.

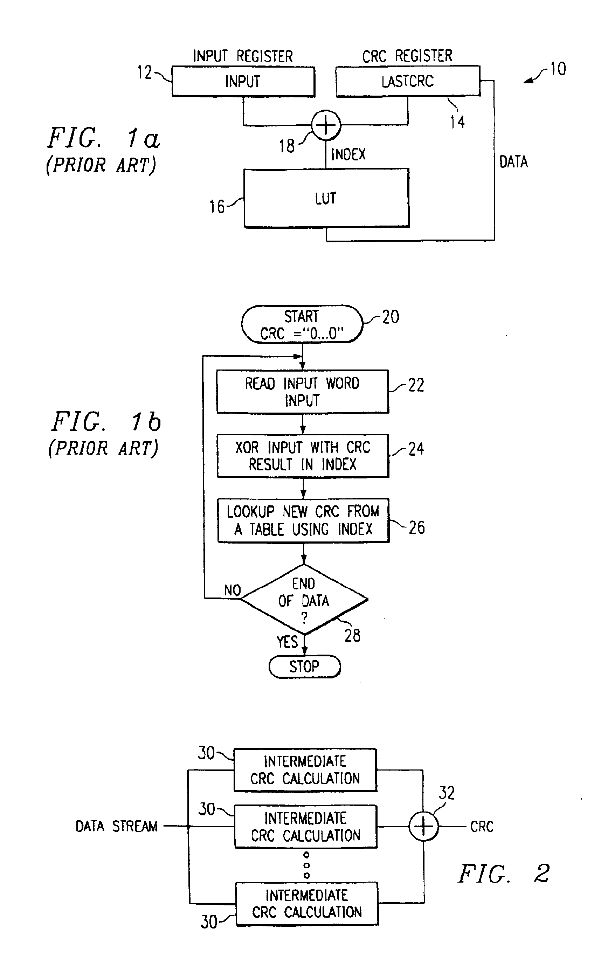

Embodiments of the present invention are best understood in relation to Figures 1 to 6 of the drawings, like numerals being used for like elements of the various drawings.

Figures 1a and 1b illustrate a block diagram and flow chart, respectively, of a prior art method and apparatus for calculating a CRC in software, using a microprocessor or DSP. For purposes of illustration, the example of Figures 1a and 1b is illustrated using an eight-bit word size; however, the method shown herein is extendible to any word length.

In Figure la, a processor 10 uses two registers in the CRC calculation: (1) an input register 12 and a CRC register 14. A look up table (LUT) 16 (typically a portion of a larger memory in the processor) stores a table of CRC values. The input register 12 receives data from a data stream for which a CRC calculation is desired. The value stored in the input register 12 is denoted as INPUT. The CRC register 14 receives CRC values read from the LUT 16. The value stored in index register 14 is denoted LASTCRC. An exclusive-or operation (shown as exclusive-or block 18) is performed on the contents of the input register 12 (INPUT) and the CRC register 14 (LASTCRC), using modulo-2 addition. The output of exclusive-or gate 18 is used by the CRC calculation program to address the LUT 16. The output of the exclusive-or gate 18 is denoted as INDEX.

In operation, the circuit of Figure 1 generates the CRC by the method shown in Figure 1b. In block 20, the circuit is initialized, with the CRC register 14 storing a LASTCRC value of "0000000." In block 22, the data stream is received into the input register 12 to form a word (INPUT). In block 24, INPUT and LASTCRC are added using modulo-2 addition to generate address INDEX. The value in the LUT 16 at location INDEX is accessed and subsequently stored in the CRC register 14 in block 26. If the data in the packet for which the CRC is being generated is finished in decision block 28, then the calculation is finished, and the CRC for the packet is available in the CRC register 14. If there are more words to process in the packet, then the flow returns to block 22, where the next input word is stored in the input register 12.

The method illustrated in Figure 1b is particularly inefficient in a pipelined architecture. Pipelined architectures provide efficient processing by performing additional operations during latencies caused by a particular operation. As can be seen from the flow chart of Figure 1b, however, during the read latency in step 26, only the next data word can be read in step 22. Step 24 cannot be started until after completion of step 26, since step 24 has a dependency on step 26. This dependency creates a bottleneck in the operation of the processor.

Figure 2 illustrates a diagram illustrating a preferred embodiment for improving the efficiency of generating a CRC on a data stream. In this embodiment, the data stream is split into multiple data streams. Each of the multiple data streams is processed separately in process blocks 30 to generate an intermediate CRC result. The intermediate CRC results are then combined using modulo-2 adder 32 to generate the final CRC result.

The flow model of Figure 2 provides a significant advantage over the prior art model shown in Figures 1a and 1b. In the prior art method shown in Figures 1a and 1b, a read operation of the LUT can start only after the previous read of the LUT 16 is completed, because the address associated with a read operation is dependent upon the result of the previous read operation. In the flow model of Figure 2, multiple, independent CRC generations are interleaved in the pipeline such that multiple read operations performed in conjunction with the multiple independent data streams overlap in the pipeline, making improved use of the pipelined architecture. Accordingly, the generation of the CRC is more efficient.

To describe how the data stream is split, it should be noted that the look-up table is a linear transformation of the data. If we denote the look-up table transformation as T and the input words of a packet as $d_0 - d_m$, where m is the number of words in a packet, the CRC computation can be described by the following expression (throughout this document, "+" will be used to denote modulo-2 addition):

$$CRC = T(...T(T(T(T(T(T(T(d_0)+d_1)+d_2)+d_3)+d_4)+d_5)...+d_m)$$

Since the CRC transformation is linear, $T(T(d_x)+d_{x+1})=T(T(d_x)+T(d_{x+1}))$. By defining $U=T^2(d_x)=T(T(d_x))$, the equation for the CRC value presented above can be rewritten as:

$$CRC = U(...(U(U(U(d_0)+d_2)+d_4)+d_6)...)+T(...U(U(U(d_1)+d_3)+d_5)...)$$

The right hand side of the above equation comprises two independent terms: (1) $U(...(U(U(U(d_0)+d_2)+d_4)+d_6)...)$ and (2) $T(...U(U(U(d_1)+d_3)+d_5)...)$. An intermediate CRC for each of these two terms can be computed independently of the other (i.e., computation of one of the intermediate CRC terms does not have any dependencies related to the computation of the other intermediate CRC term) by using a $U(d_x)$ LUT. The $U(d_x)$ LUT can be generated easily from the $T(d_x)$ look-up table (shown in greater detail in connection with Figure 5a). Accordingly, twice as many data words can be processed during a single iteration. The final $T(d_x)$ transformation can be done either manually (to conserve memory) or by using a $T(d_x)$ LUT.

It should be noted that the transformation denoted by $U(d_x)$ does not require any more storage than that used by the $T(d_x)$ LUT. The size of the look-up table is determined by the order of the CRC polynomial.

The equations shown above can be extended further to accommodate multiple data streams in excess of two. By defining a transformation $V(d_x)=T^3(d_x)=T(T(T(d_x)))$, the equation for the CRC can be rewritten as:

$$CRC = V(...(V(V(d_0)+d_3)+...)+U(...V(V(d_1)+d_4)...)+T(V(V(d_2)+d_5)+...)$$

As can be seen from this equation, the CRC calculation can be broken down into three independent data streams that can be simultaneously processed in one loop iteration by using a $V(d_x)$ LUT. Once again, the $V(d_x)$ LUT does not require any more memory than is needed for the $T(d_x)$ LUT. The single $U(d_x)$ and $T(d_x)$ transformations can be easily accomplished by direct computation without the need for additional tables.

The above-described approach of separating the calculation of the CRC into multiple independent processes that can be simultaneously executed in a processor's pipeline (or pipelines) works very efficiently with microprocessors and DSPs.

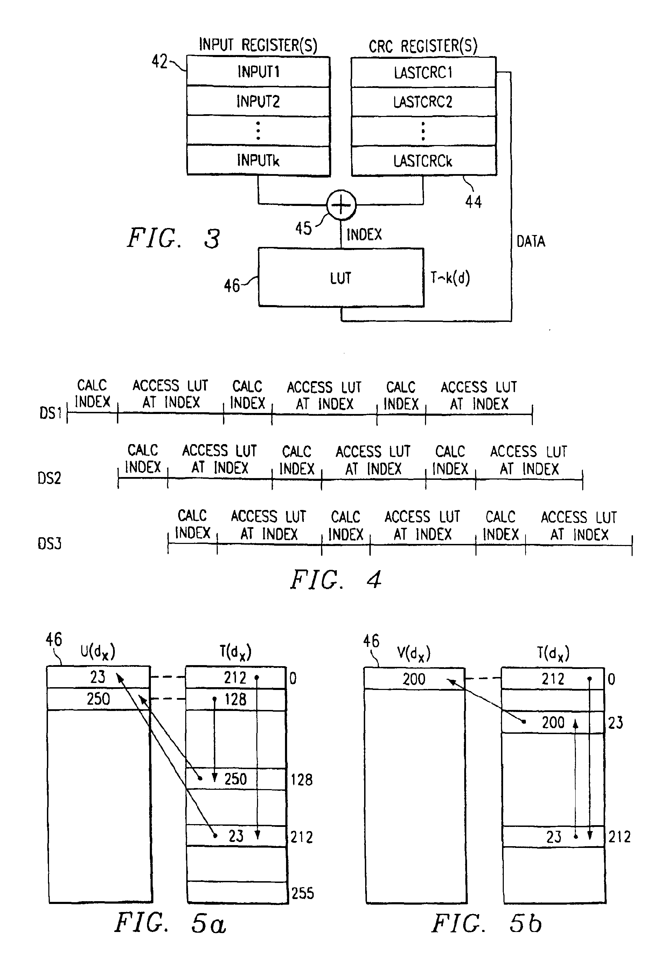

Figure 3 illustrates a structural depiction for a processor implementing the CRC method of Figure 2. In this embodiment, the processor 40, which could be a microprocessor or a DSP, divides the data stream into k intermediate data streams, as described in connection with Figure 2. Bits from each of the k data streams are grouped into words in a respective input register 42 (or portion thereof). Accordingly, bits from data stream 1 are grouped into words in INPUT1, bits from data stream 2 are grouped into words in INPUT2, and so on. For each of the k INPUT values, a corresponding CRC register 44 stores a LASTCRC value. Once a word is formed in an input register 12, the processor adds the word to the corresponding LASTCRC value (using modulo-2 adder 45) to determine an address. This address is used to obtain a new value for LASTCRC from the LUT 46.

Many present day DSPs and other processors incorporate memory that can receive an address on every clock cycle. Some processors have dual-ported memories which can receive two addresses per clock cycle. Because the address calculation for a read operation of the LUT 46 associated with one intermediate data stream is not dependent upon the address calculation for read operations performed in conjunction with the other intermediate data streams, read operations associated with the multiple intermediate data streams can overlap in the pipeline, i.e., a read operation associated with one of the data streams can begin prior to completion of the read operation associated with other intermediate data streams.

As shown in Figure 3, any number of independent, intermediate data streams can be used. For simplicity, in Figure 3, only a single modulo-2 adder is shown. However, in practical microprocessors and DSPs, there can be a number of such adders that can be run simultaneously. The number of independent processes used in a particular implementation can be set at the number that most efficiently uses the pipeline architecture of the processor. In a particular present day DSP architecture, it has been found the use of up to four independent data streams can be supported without significantly affecting the other operations of the processor; however, the availability of resources is very dependent upon the particular processor architecture and, therefore, the optimal number of independent data streams will vary from processor to processor.

Figure 4 illustrates a basic timing diagram showing the overlapping calculations of the intermediate CRC values. As can be seen from Figure 4, while the calculation of a LUT address for a single intermediate data stream cannot begin prior to completion of the previous read for that particular intermediate data stream, the processing of multiple, independent intermediate data streams results in a throughput which is much greater than prior art systems.

Figure 5a provides a diagram showing how the $U(d_x)$ can be easily derived from the $T(d_x)$ table. For each location in the $U(d_x)$ table, the corresponding position in the $T(d_x)$ table is used as an address for the $U(d_x)$ CRC value. Similarly, as shown in Figure 5b, $V(d_x)$ table can easily be derived from the $T(d_x)$ table. For each location in the $V(d_x)$ table, the corresponding address in the $T(d_x)$ points to the address for the $V(d_x)$ value.

The embodiment of the invention described in connection with Figures 2-5 provides significant advantages over the prior art. In particular, the effective number of cycles used to calculate the CRC on a data stream is greatly reduced, due to the reduction of wasted processing cycles caused by read latencies and dependencies.

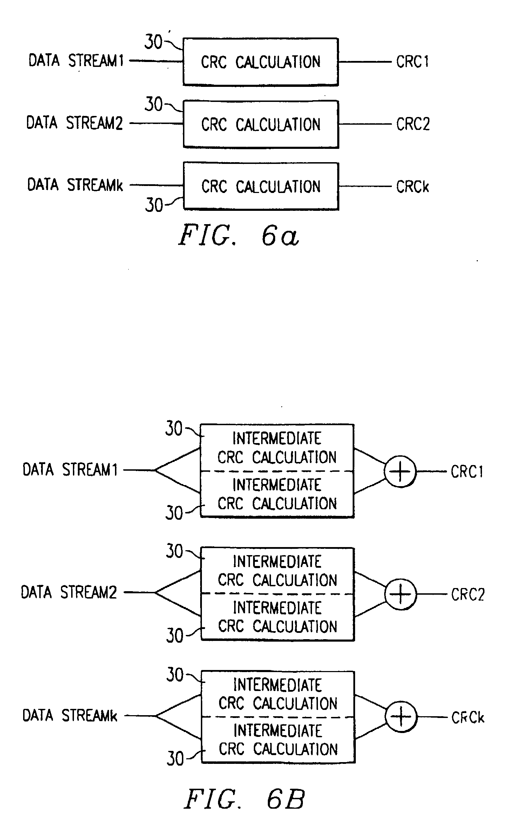

Figure 6a illustrates a second embodiment of the present invention. In this embodiment, the routine for generating the CRC from a data stream receives data from multiple data streams which are independent and produces multiple CRCs, as opposed to the multiple independent intermediate data streams derived from a single data stream to generate a single CRC, as discussed above. This method allows parallel CRC processing for more than one input data word and may be combined with the method of producing multiple intermediate data streams from a single stream (see Figure 6b).

This method is useful for systems that require separate CRC computations for more than one input data stream. Such systems include those that protect different classes of data with a separate CRC, as well as those systems that allow processing of incoming and outgoing data streams simultaneously. One such system is an ITU T1.413 standard based modem, where two classes of data (called fast and interleave data) are protected by two separate CRCs, each of which is independent of the other.

As discussed in connection with Figures 1a and 1b, current day methods to compute CRC based on processing one word at a time are inefficient for processors because read latencies set a lower bound on the number of instruction cycles to complete one loop iteration.

Since the minimum number of instruction cycles in a loop is determined primarily by the read access latency, there will be several unutilized processor resources during each loop iteration. However, if more than one independent data stream is processed in each loop, the total execution time for the CRC computation can be significantly reduced. This is accomplished by taking advantage of the fact that two or more words from independent data streams can be read and processed in one iteration without affecting the read latency requirements of either.

As shown in Figure 6b, the method of Figure 6a can be combined with the teachings of Figures 2-5 to further optimize use of a pipelined architecture, where appropriate. In this method, each of the multiple data streams is separated into multiple intermediate data streams. An intermediate CRC value is generated for each intermediate data stream; associated intermediate CRCs are added together to generate the final CRC values.

One advantage of processing two data streams in parallel is that the function call overhead is reduced to half. This is important for VLIW (Very Long Instruction Word) type microprocessors, such as the TEXAS INSTRUMENTS TMS320C6xx in particular, because setting up a code loop for software pipelining consumes a significant number of processor cycles.

Although the Description of the invention has been directed to certain exemplary embodiments, various modifications of these embodiments, as well as alternative embodiments, will be suggested to those skilled in the art. The invention encompasses any modifications or alternative embodiments that fall within the scope of the Claims.

In view of the foregoing description it will be evident to a person skilled in the art that various modifications may be made within the scope of the invention.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims and features from respective independent claims may be combined in any appropriate manner and not merely in the specific combinations enumerated in the claims.

Insofar as embodiments of the invention described above are implementable, at least in part, using a software-controlled programmable processing device such as a Digital Signal Processor, microprocessor, other processing devices, data processing apparatus or computer system, it will be appreciated that a computer program for configuring a programmable device, apparatus or system to implement the foregoing described methods is envisaged as an aspect of the present invention. The computer program may be embodied as source code and undergo compilation for implementation on a processing device, apparatus or system, or may be embodied as object code. The skilled person would readily understand that the term computer in its most general sense encompasses programmable devices such as referred to above, and data processing apparatus and computer systems.

Suitably, the computer program is stored on a carrier medium in machine or device readable form, for example in solid-state memory or magnetic memory such as disc or tape and the processing device utilises the program or a part thereof to "configure it for operation. The computer program may be supplied from a remote source embodied in a communications medium such as an electronic signal, radio frequency carrier wave or optical carrier wave. Such carrier media are also envisaged as aspects of the present invention.

**Claims**

1. A method of calculating a cyclic redundancy check in a pipelined processor, comprising the steps of:

   receiving a data stream; separating the data stream into two or more intermediate data streams;
   calculating intermediate cyclic redundancy checks on each intermediate data stream;
   generating a cyclic redundancy check from said intermediate cyclic redundancy checks.

2. The method of claim 1 wherein said step of calculating intermediate cyclic redundancy checks on each intermediate data stream comprises the step of contemporaneously calculating intermediate cyclic redundancy checks on each intermediate data stream.

3. The method of claim 1 or 2, wherein said generating step comprises the step of adding said intermediate cyclic redundancy checks using modulo-2 addition.

4. The method of any preceding claim, wherein said calculating step comprises the steps of:
    for each intermediate data stream, repeating said steps of:

   generating a data word from the intermediate data stream;
   adding said word to a current cyclic redundancy check stored in a first memory associated with the intermediate data stream to form an address;
   retrieving a new cyclic redundancy check from a second memory location corresponding to said address; and
   replacing said current cyclic redundancy check with said new cyclic redundancy check.

5. The method of claim 4 wherein said generating and adding steps associated with one of said intermediate data streams are performed contemporaneously with said retrieving step associated with another of said intermediate data streams.

**6.** The method of claim 4 or 5, wherein said retrieving step associated with one of said intermediate data streams is performed contemporaneously with said retrieving step associated with another of said intermediate data streams.

**7.** The method of any one of claims 4 to 6, wherein said generating, adding, retrieving and replacing steps are repeated until a packet of data from said intermediate data stream is processed.

**8.** The method of any preceding claim, wherein said step of separating said data into two or more streams comprises the step of separating the data stream into three or more intermediate data streams.

**9.** A method of calculating cyclic redundancy checks in a pipelined processor, comprising the steps of:

receiving multiple independent data streams; and
contemporaneously, for each independent data stream,

repeating said steps of:

generating a data word from the independent data stream;
adding said data word to a current cyclic redundancy check stored in a first memory associated with the intermediate data stream to form an address;
retrieving a new cyclic redundancy check from a second memory location corresponding to said address; and
replacing said current cyclic redundancy check with said new cyclic redundancy check.

**10.** The method of claim 9 wherein said generating and adding steps associated with one of said independent data streams are performed contemporaneously with said retrieving step associated with another of said independent data streams.

**11.** The method of claim 9 or 10, wherein said retrieving step associated with one of said independent data streams is performed contemporaneously with said retrieving step associated with another of said independent data streams.

**12.** Circuitry for generating cyclic redundancy checks, comprising:

circuitry for providing two or more independent data streams; and
circuitry for calculating an separate cyclic redundancy checks on each intermediate data stream using pipelined execution of instructions, such the instructions associated with one of said independent data streams are being executed contemporaneously with instructions associated with another independent data stream.

**13.** The circuitry for generating cyclic redundancy checks of claim 12 and further comprising circuitry for generating a cyclic redundancy check from said separate cyclic redundancy checks.

**14.** The circuitry for generating cyclic redundancy checks of claim 13 wherein said circuitry for generating a cyclic redundancy checks from said separate cyclic redundancy checks comprises one or more modulo-2 adders.

**15.** The circuitry for generating cyclic redundancy checks of any one of claims 12 to 14, and further comprising circuitry for separating a single data stream into multiple intermediate data streams.

**16.** The circuitry for generating cyclic redundancy checks of claim 15 wherein circuitry for separating includes a first set of registers for storing data words from each intermediate data stream.

**17.** The circuitry for generating cyclic redundancy checks of any one of claims 12 to 16, wherein said calculating circuitry includes a second set of registers for storing current cyclic redundancy check values for each intermediate data stream.

**18.** The circuitry for generating cyclic redundancy checks of any one of claims 12 to 17, wherein said calculating circuitry further includes a modulo-2 adder for adding data stored in said first set of registers with data stored in said second set of registers.

**19.** The circuitry for generating cyclic redundancy checks of any one of claims 12 to 17, wherein said calculating circuitry further comprises a cyclic redundancy check look-up table.

**20.** A program for a computer, comprising computer program elements for implementing any one of the methods according to claims 1 to 11.

**21.** A program for a computer, comprising computer program elements translatable for implementing any one of the methods according to claims 1 to 11.

**22.** A carrier medium, carrying a computer program according to claim 20 or 21.

## FIG. 1a
## (PRIOR ART)

INPUT REGISTER

CRC REGISTER

12 INPUT

LASTCRC 14

10

18 ⊕ INDEX

DATA

16 LUT

## FIG. 1b
## (PRIOR ART)

START
CRC = "0...0" 20

READ INPUT WORD
INPUT 22

XOR INPUT WITH CRC
RESULT IN INDEX 24

LOOKUP NEW CRC FROM
A TABLE USING INDEX 26

NO

END
OF DATA
? 28

YES

STOP

30 INTERMEDIATE
CRC CALCULATION

32

30 INTERMEDIATE
CRC CALCULATION

DATA STREAM ⊕ CRC

○
○
○

30 INTERMEDIATE
CRC CALCULATION

## FIG. 2

INPUT REGISTER(S)    CRC REGISTER(S)

42

| INPUT1 | | LASTCRC1 |
| INPUT2 | | LASTCRC2 |
| ⋮ | | ⋮ |
| INPUTk | | LASTCRCk |

44

45 — ⊕

INDEX

DATA

46 — LUT    T~k(d)

*FIG. 3*

DS1  | CALC INDEX | ACCESS LUT AT INDEX | CALC INDEX | ACCESS LUT AT INDEX | CALC INDEX | ACCESS LUT AT INDEX |

DS2  | CALC INDEX | ACCESS LUT AT INDEX | CALC INDEX | ACCESS LUT AT INDEX | CALC INDEX | ACCESS LUT AT INDEX |

DS3  | CALC INDEX | ACCESS LUT AT INDEX | CALC INDEX | ACCESS LUT AT INDEX | CALC INDEX | ACCESS LUT AT INDEX |

*FIG. 4*

46  $U(d_x)$    $T(d_x)$

| 23 | | 212 | 0 |
| 250 | | 128 | |
| | | 250 | 128 |
| | | 23 | 212 |
| | | | 255 |

*FIG. 5a*

46  $V(d_x)$    $T(d_x)$

| 200 | | 212 | 0 |
| | | 200 | 23 |
| | | 23 | 212 |

*FIG. 5b*

DATA STREAM1 ——— 30 [ CRC CALCULATION ] ——— CRC1

DATA STREAM2 ——— 30 [ CRC CALCULATION ] ——— CRC2

DATA STREAMk ——— [ CRC CALCULATION ] ——— CRCk
30

*FIG. 6a*

DATA STREAM1 — 30 [ INTERMEDIATE CRC CALCULATION / INTERMEDIATE CRC CALCULATION ] 30 — ⊕ — CRC1

DATA STREAM2 — 30 [ INTERMEDIATE CRC CALCULATION / INTERMEDIATE CRC CALCULATION ] 30 — ⊕ — CRC2

DATA STREAMk — 30 [ INTERMEDIATE CRC CALCULATION / INTERMEDIATE CRC CALCULATION ] 30 — ⊕ — CRCk

*FIG. 6B*

**EP 1 087 534 A1**

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | WO 99 37030 A (DESJARDINS PHILIP A ;MANTRI RAVI G (US); 3COM CORP (US)) 22 July 1999 (1999-07-22) * abstract; figure 5 * * page 4, line 17 - line 29 * * page 7, line 28 - page 15, line 26; figures 3-5 * | 1-22 | H03M13/09 |
| A | US 5 619 516 A (LI SHIPING ET AL) 8 April 1997 (1997-04-08) * column 8, line 17 - line 56; figure 5 * * column 11, line 20 - line 36; figure 7 * | 1-22 | |
| A | US 5 951 707 A (CHRISTENSEN KENNETH JUSSI ET AL) 14 September 1999 (1999-09-14) * abstract; figures 4,5 * | 1-22 | |

TECHNICAL FIELDS SEARCHED (Int.Cl.7)

H03M

The present search report has been drawn up for all claims

| Place of search | Date of completion of the search | Examiner |
|---|---|---|
| MUNICH | 27 November 2000 | Farman, T |

## ANNEX TO THE EUROPEAN SEARCH REPORT
## ON EUROPEAN PATENT APPLICATION NO.

EP 00 30 8425

This annex lists the patent family members relating to the patent documents cited in the above-mentioned European search report.
The members are as contained in the European Patent Office EDP file on
The European Patent Office is in no way liable for these particulars which are merely given for the purpose of information.

27-11-2000

| Patent document cited in search report | | Publication date | Patent family member(s) | | | Publication date |
|---|---|---|---|---|---|---|
| WO 9937030 | A | 22-07-1999 | US | 6029186 | A | 22-02-2000 |
| | | | AU | 2325699 | A | 02-08-1999 |
| US 5619516 | A | 08-04-1997 | AU | 659971 | B | 01-06-1995 |
| | | | AU | 5846394 | A | 19-07-1994 |
| | | | CA | 2129236 | A,C | 07-07-1994 |
| | | | EP | 0631703 | A | 04-01-1995 |
| | | | JP | 7504312 | T | 11-05-1995 |
| | | | WO | 9415407 | A | 07-07-1994 |
| US 5951707 | A | 14-09-1999 | NONE | | | |